(19) Europäisches Patentamt
European Patent Office
Office européen des brevets

(11) Veröffentlichungsnummer: **0 166 938**
**A2**

# (12) EUROPÄISCHE PATENTANMELDUNG

(21) Anmeldenummer: 85106248.9

(22) Anmeldetag: 22.05.85

(51) Int. Cl.[4]: G 11 C 11/22

(30) Priorität: 01.06.84 DE 3420509
18.10.84 DE 3438111
26.10.84 DE 3439283

(43) Veröffentlichungstag der Anmeldung:
08.01.86 Patentblatt 86/2

(84) Benannte Vertragsstaaten:
AT BE CH DE FR GB IT LI LU NL SE

(71) Anmelder: BAYER AG
Konzernverwaltung RP Patentabteilung
D-5090 Leverkusen 1 Bayerwerk(DE)

(72) Erfinder: Eiling, Aloys, Dr.
Schmiedestrassse 12
D-4630 Bochum 6(DE)

(72) Erfinder: Pott, Richard, Dr.
Burscheiderstrasse 225
D-5090 Leverkusen 3(DE)

(72) Erfinder: Kämpf, Günther, Prof. Dr.
Wöhlerstrasse 4
D-4150 Krefeld(DE)

## (54) Verfahren zum Ein- und Auslesen von Signalen auf Basis elektrisch polarisierbarer Schichten.

(57) Als Datenspeicher wird eine elektrisch polarisierbare und mit einem Elektrodensystem versehene Polymerschicht benutzt. Die zu speichernden elektrischen Signale werden durch remanente Polarisierung einzelner Domänen in der Polymerschicht aufgezeichnet. Die eingeschriebene remanente Polarisation bleibt auch nach dem Abschalten des Signalfeldes erhalten. Der Auslesevorgang beruht auf einer piezoelektrischen oder pyroelektrischen Aktivierung der polarisierten Domänen. Die Aktivierung erfolgt in der Weise, daß eine Vielzahl der polarisierten Domänen gleichzeitig elektrische Signale im Elektrodensystem induzieren, die dann parallel und/oder nach einem Multiplexverfahren zugeordnet und abgefragt werden. Die eingeschriebene remanente Polarisation wird normalerweise durch freie Ladungsträger abgeschirmt, so daß an der Außenseite kein elektrisches Feld auftritt. Durch die Aktivierung wird nun in der Weise eine Störung des Systems durchgeführt, daß die abschirmende Wirkung der Kompensationsladungen vorübergehend aufgehoben wird und dadurch ein Signalfeld hervorgerufen wird, das zum Auslesen benutzt wird. Bei einem mit einem Elektrodensystem versehenen Speicher können die einer einzigen Leiterbahn zugeordneten polarisierten Domänen der Polymerschicht simultan pyroelektrisch durch einen Heizstromimpuls bzw. piezoelektrisch durch Druck oder Zug aktiviert werden. Auf diese Weise können die der Leiterbahn zugeordneten polarisierten Bereiche gleichzeitig abgefragt werden und dann durch ein Überwechseln auf eine andere Leiterbahn die entsprechenden anderen Bereiche alktiviert werden, so daß insgesamt ein selektiv paralleler Auslesemodus ermöglicht wird.

Croydon Printing Company Ltd

0166938

BAYER AKTIENGESELLSCHAFT
5090 Leverkusen, Bayerwerk

Konzernverwaltung RP
Patentabteilung
Ki/Kn

Verfahren zum Ein- und Auslesen von Signalen auf Basis elektrisch polarisierbarer Schichten

Die Erfindung betrifft ein Verfahren zum Ein- und Auslesen von binären oder analogen elektrischen Signalen unter Verwendung eines Datenspeichers auf Basis einer elektrisch polarisierbaren und mit einem Elektrodensystem kontaktierten Polymerschicht. Der Einlesevorgang beruht darauf, daß die Polymerschicht entsprechend den aufzuzeichnenden Signalen in lokalen Domänen remanent polarisiert wird. Der Auslesevorgang beruht auf einer piezoelektrischen oder pyroelektrischen Aktivierung der polarisierten Domänen.

Die gegenwärtige Situation auf dem Gebiet der Kommunikationstechnik, insbesondere dem Gebiet der Datenverarbeitung, ist gekennzeichnet durch die Entwicklung und den Einsatz von Informationsspeichern mit immer höherer Datendichte. Derzeit sind kommerziell im Einsatz vorrangig stationäre elektrische Speicher auf Si-Basis (ROM, RAM, CCD) mit Speicherdichten um $10^6$ bit $cm^{-2}$ und bewegliche magnetische Speicher (Band, Platte, Trommel) um $10^7$ bit $cm^{-2}$. In Entwicklung befinden sich elektrische Speicher höherer Dichte (Herstellung mit Hilfe von Elektronenstrahl- bzw. Röntgenstrahl-Lithographie), magnetische Speicher höherer Dichte (Ersatz der Pigment/Bindemittelsysteme durch metallische Schichten, Einführung der "perpendicular recording"-Technik) sowie optische Speicher, insbesondere nicht löschbare optomechanische Speicher, z. B. Bildplatte, und

löschbare optomagnetische Speicher auf Basis Kerr- oder Faraday-Effekt. Alle diese Speicher werden - zumindest in absehbarer Zeit - nicht größere Speicherdichten als ca. $10^8$ bit $cm^{-2}$ erreichen; so sind z. B. die optischen Speicher durch die maximale Bündelung des Laserstrahles von ca. 1 $\mu m^2$ in ihrer Speicherdichte begrenzt.

Gewünscht und dringend gebraucht aber werden Speicher mit wesentlich höheren Speicherdichten als $10^8$ bit/$cm^{-2}$. Neben der Speicherdichte sind weitere wichtige Größen die Zugriffszeit, Datenübertragungsrate, Kosten pro bit, Lebensdauer der gespeicherten Informationen und Kompatibilität zu bestehenden Rechnersystemen. Folgende Daten werden als Zielgrößen für Speicher der 90er Jahre angestrebt:

| | |
|---|---|
| Speicherdichten | $10^{11}$ bit/$cm^2$ |
| Zugriffszeiten | $10^{-8}$ sec |
| Datenübertragungsraten | $10^8$ bit/sec |
| Permanenz | 10 Jahre |
| und löschbar. | |

Wesentliche Entwicklungsziele sind eine höhere Speicherdichte und eine kürzere Zugriffszeit. Verfolgt werden derzeit zwei Entwicklungsrichtungen:

a) Bei der "mehrdimensionalen Speicherung" mittels der Laser-Holographie oder mittels "fotochemischem Lochbrennen" wird die Information mit einem Laserstrahl in das Speichermedium eingeschrieben. Bei holographischen Systemen wird die Information räumlich drei-dimensional gespeichert (z. B. in $LiNbO_2$ oder in Polymeren). Beim fotochemischen Lochbrennen wird die Information mittels des Lasers eingelesen, aber zusätzlich werden pro Flä-

chenelement (ca. 1 $\mu m^2$) in eine breitbandige Festkörper-IR-Absorptionsbande (Breite ca. 500 GHz) bis zu $10^3$ unterschiedliche schmale Banden ("Löcher") mit einer Bandbreite von 50 MHz eingebrannt. In beiden Fällen besteht der Nachteil, daß nicht bit für bit gelöscht und wieder eingelesen werden kann, sondern die Löschung stets paketweise, z. B. á $10^3$ bit beim fotochemischen Lochbrennen, erfolgt.

b) Die zweite Entwicklungsrichtung befaßt sich mit der Verwendung von Elektronenstrahlen zum Ein- bzw. Auslesen. Der Elektronenstrahl hat gegenüber dem Laser den Vorteil eines erheblich geringeren Strahldurchmessers (Größenordnung 0,005 $\mu m$). Dementsprechend wird eine höhere Ortsauflösung und damit eine höhere Speicherdichte erreicht. Mit dieser Methode wurde in neuerer Zeit ein nicht lösch- und nicht wiedereinschreibbarer Speicher durch Einbrennen winziger Löcher in ß-Aluminium hergestellt.

Speicher auf Basis elektrisch polarisierbarer Schichten werden seit 1950 entwickelt. In dem US-Patent 2 698 928 sind die grundlegenden Verfahren für einen beweglichen Speicher beschrieben. Hierbei wird ein Band/Platte bestehend aus einem elektrisch remanent polarisierbaren Material, das eine elektrisch leitende Unterschicht besitzt, an einer Elektrode vorbeibewegt. Durch Beaufschlagung der Elektrode mit einer Spannung werden Bereiche der elektrisch polarisierbaren Schicht remanent polarisiert und dadurch Information gespeichert. Die Elektrode kann sich sowohl in direktem Kontakt mit der Schicht befinden als auch einen definierten Abstand aufweisen. Andere Verfahren zur Erzeugung remanent polarisierter Bereiche sind

die Verwendung von Elektronenstrahlen bzw. Ionenbeschuß. Zum Auslesen der gespeicherten Information wird der piezoelektrische Effekt verwendet, d. h. auf die elektrisch polarisierbare Schicht wird ein Zug/Druck durch Vorbeibewegen an einer scharfen Kante oder durch Verwendung von Ultraschall ausgeübt, so daß die freigesetzten Ladungen eine Spannung in der Elektrode induzieren, die proportional zu der beim Schreibvorgang verwendeten Spannung ist. Als elektrisch polarisierbare Medien werden anorganische Ferroelektrika aber auch elektrisch polarisierbare Kunststoffe genannt.

Neben der piezoelektrischen Auslesung wurde Ende der sechziger Jahre bei bandförmigen Speichern zur Auslesung der pyroelektrische Effekt verwendet (H. Tanaka, R. Sato, Trans. I.E.C.J. <u>52-A</u>, 436 (1969); H. Niitsuma, R. Sato, Ferroelectrics <u>34</u>, 37 (1980)). Hierbei wurden Spannungen durch Erhitzen der elektrisch polarisierten Schicht in den abgreifenden Schleif-Elektroden erzeugt. Als elektrisch polarisierbare Schicht wurden anorganische Materialien wie $Pb(ZrTi)O_3$ (=PZT) verwendet.

Eine Weiterentwicklung zu einem Speicher hoher Dichte ist nicht bekannt. Eine solche Weiterentwicklung dürfte auch nicht erfolgversprechend sein, da keramische Ferroelektrika, wie z. B. PZT, wegen ihrer hohen Dielektrizitätskonstanten und ihrer gleichzeitig niedrigen Koerzitivkraft nicht geeignete, elektrisch polarisierbare Materialien für Speicher höchster Dichte darstellen. Die hohe Dielektrizitätskonstante hat ein niedriges Auslesesignal zur Folge und die niedrige Koerzitivkraft führt zu einer geringen Speicherdichte. In einem zu dem von Tanaka und Sato vorgeschlagenen analogen Verfahren unter Verwendung von Schleif-elektroden und pyroelektrischer Auslesung wird in dem US-Patent 4 389 445 eine polarisierbare makromolekulare Schicht, wie z. B. Polyvinilydenfluorid (PVDF) eingesetzt, die aus den oben angegebenen Gründen grundsätzlich besser als anorganische Materialien geeignet ist. Ebenfalls auf PVDF-Basis wurde ein Datenspeicher in dem US- Patent 4 059 827 beschrieben, wobei das Einlesen direkt mit Elektronenstrahl und das Auslesen über die Aufweitung des Elektronenstrahls an polarisierten PVDF-Domänen erfolgt. Eine Einlesung mittels Elektronenstrahl bringt aber die Gefahr mit sich, daß bei Elektronenbeschuß mit höheren Stromdichten eine Abspaltung von Fluor aus dem PVDF und damit eine irreversible Zerstörung des Speichermaterials stattfindet. Weiterhin kann bei dem oben beschriebenen Verfahren das Einlesen der Information mittels Elektronenstrahl nur nach Aufheizung der PVDF-Folie über eine bestimmte Temperatur ($80^{O}$ C) incl. Abkühlung nach dem Einlesevorgang bewerkstelligt werden. Damit sind - wegen der thermischen Trägheit des Polymermaterials - nur äußerst niedrige Datenübertragungsraten möglich, die für die Praxis uninteressant sind. Die Datenübertragungsrate stellt bei dem Schleifelektrodenverfahren kein Problem dar. Der entscheidende Nachteil, der aber allen beweglichen Speichern anhaftet, ist die Zugriffszeit, die bedingt durch den Positionierungsprozeß immer einige $10^{-3}$sec. betragen wird.

Dieses Problem tritt bei den stationären Speichern auf Si-Basis nicht auf. Deshalb wurden parallel zu den Speichern auf Si-Basis auch stationäre Speicher auf Basis elektrisch polarisierbarer Medien entwickelt. So wurde von Crawford (J. C. Crawford, Ferroelectrics 3, (1972)) eine ferroelektrische Speicheranordnung beschrieben, die kompatibel zu den damaligen elektrischen Speichern auf Si-Basis war. Bei diesem Speicher wurden Elektrodenstreifen (sog. Kammelektrode) auf der Ober- und Unterseite einer keramischen ferroelektrischen Schicht (PZT) um 90° gegeneinander gedreht aufgedampft. Information konnte gespeichert werden, indem durch Anlegen einer Spannung an entsprechende Elektroden auf Ober- und Unterseite der Bereich im Kreuzungspunkt dieser Elektroden polarisiert wurde. Unterhalb der ferroelektrischen Schicht war eine Epoxy-Schicht aufgebracht, auf der wiederum ein piezoelektrisches Material geklebt wurde. Diese piezoelektrische Schicht wurde selektiv durch Anlegen einer Spannung in Schwingungen versetzt, so daß die entstandene Schallwelle über den Epoxy-Kleber Druck/Zug auf die ferroelektrische Speicherschicht ausübt und dadurch wiederum mittels des piezoelektrischen Effektes eine Spannung in dem entsprechenden Elektrodenpaar erzeugt wurde, die je nach Vorzeichen der in dem polarisierten Bereich vorliegenden remanenten Polarisation positiv oder negativ war.

Mit diesem Vorschlag ist aber ein Speicher hoher Datendichte nicht raelisierbar, da wegen der notwendigen Dicke der Epoxy-Schicht (bei 10 MHz zumindest 0,5 mm) schmale Elektroden ( $< 100\ \mu m$), die ja erst große Speicherdichten ermöglichen würden, nicht selektiv genug ansprechbar sind und zudem die unvermeidbar auftretenden Schallreflexionen zeitverzögert auch nichtadressierte Bereiche ansprechen, so daß durch räumliche Interferenz teilweise völlig falsche Auslesedaten erhalten wurden.

Ein ähnliches Kammelektrodensystem aufgebracht auf ein Polymer, wie z. B. PVDF, wird in dem US-Patent Nr. 3 772 518 vorgestellt. In diesem Patent wird allerdings nicht an Datenspeicherung gedacht, sondern ausschließlich an ein

Lichtdetektionssystem ähnlich wie bei einer VIDICON-Röhre. Hierbei fällt ein feiner Lichtstrahl auf eine einheitlich vorpolarisierte organische Folie, so daß unter Ausnutzung des pyroelektrischen Effektes mittels Kammelektroden die Position des einfallenden Lichtstrahls detektiert werden kann. Die hierbei registrierten Ströme betragen ca. $10^{-11}$ A. Durch Beaufschlagen der aufgebrachten Kammelektroden mit einer Spannung können analog zu Crawford Informationen gespeichert werden und mittels des feinen Lichtstrahls ausgelesen werden. Es ergibt sich aber wiederum das Problem der Positionierung des Lichtstrahls, das zu einer unerwünscht großen Zugriffszeit führt sowie die Begrenzung der Speicherdichte durch die maximal mögliche Bündelung des Laserlichtstrahls auf ca. 1 $\mu m^2$. Ideal wäre ein Speicher, der auch diesen Nachteil vermeidet und somit alle Eigenschaften der Speicher auf Silizium-Basis aufweist, jedoch Speicherdichten von $10^{10}$ bit/$cm^2$ zuläßt. Bei den Si-Speichern liegt die technologisch bedingte Grenze der Speicherdichte bei ca. $10^6$ bit/$cm^2$.

Der Erfindung liegt die Aufgabe zugrunde, in Kombination mit einem Datenspeicher auf der Basis einer ferroelektrischen Polymerschicht ein Ein- und Ausleseverfahren zu entwickeln, das höchste Speicherdichten und kürzeste Zugriffszeiten ermöglicht.

Diese Aufgabe wird, ausgehend von einer mit einem Elektrodensystem kontaktierten Polymerschicht unter Ausnutzung der remanenten elektrischen Polarisierung lokaler Domänen beim Einlesen und der piezoelektrischen oder pyroelektrischen Aktivierung beim Auslesen erfindungsgemäß dadurch gelöst, daß die piezoelektrische oder pyroelektrische Aktivierung bei oder unmittelbar vor dem Auslesevorgang derart erfolgt, daß simultan eine Vielzahl der polarisierten Domänen im Elektrodensystem induzieren, die dann parallel und/oder nach einem Multiplex-Verfahren zugeordnet und abgefragt werden.

Beim Einlesen entstehen zeitstabile polarisierte Domänen in der Polymerschicht. Die eingeschriebene remanente Polarisation wird allerdings durch freie Ladungsträger (Elektronen und Löcher) abgeschirmt, so daß nach außen nahezu kein externes elektrisches Feld dringt. Aus diesem Grunde muß eine Störung des Systems durchgeführt werden, um die abschirmende Wirkung der Kompensationsladungen vorübergehend aufzuheben. Zu diesem Zweck wird beim Auslesevorgang die Polymerschicht piezoelektrisch oder durch kurzzeitige Aufheizung pyroelektrisch aktiviert. Dabei nimmt die spontane Polarisierung ab, so daß aufgrund der dann vorhandenen Überkompensation ein äußeres Feld entgegen dem Polarisationsfeld auftritt, das als Signalfeld ausgenutzt wird.

Bei der Auslesung mittels pyroelektrischer Aktivierung wird als Elektrodensystem eine Streifenmatrix bevorzugt, die durch eine Vielzahl elektrisch leitfähiger, paralleler Streifen auf der Ober- und Unterseite der Polymerschicht gebildet wird. Bei einem derart aufgebauten Speicher können in vorteilhafter Weise die einer einzigen Leiterbahn der Streifenmatrix zugeordneten polarisierten Domänen der Polymerschicht simultan durch einen in dieser Leiterbahn fließenden Heizstromimpuls pyroelektrisch aktiviert werden. Auf diese Weise können die der Leiterbahn zugeordneten polarisierten Bereiche gleichzeitig abgefragt werden und dann durch ein Überwechseln auf eine andere Leiterbahn die entsprechenden anderen Bereiche aktiviert werden, so daß insgesamt ein selektiv paralleler Auslesemodus ermöglicht wird.

Überraschenderweise wurde gefunden, daß zur pyroelektrischen Aktivierung der Polymerschicht äußerst geringe thermische Leistungen ausreichend sind. So genügt z. B. eine Heizleistung von $10^{-7}$ Watt für eine globale Aktivierung des gesamten Speichers.

Zur Durchführung der piezoelektrischen Variante des Verfahrens wird auf die erste Polymerschicht, die mit der Elektrodenmatrix versehen ist, eine zweite Polymerschicht aufgebracht, die oben mit einer leitfähigen Schicht bedeckt wird.

Die zweite Polymerschicht ist entweder insgesamt oder nur im Bereich der Streifen der oberen Kammelektrode remanent polarisiert. Eine elektrische Spannung zwischen der oberen leitfähigen Schicht und den Streifen der Kammelektrode führt dazu, daß die Polymerschicht im Bereich der Streifen einen piezoelektrisch aktivierten Druck/Zug auf die untere erste Polymerschicht ausübt. Dieser Zug/Druck erzeugt bzgl. der kreuzenden Elektroden auf der Unterseite der ersten Schicht eine elektrische Spannung, die als Signal verwendet werden kann.

Bei einem derart aufgebauten Speicher können in vorteilhafter Weise die einer einzigen oberen Leiterbahn der Streifenmatrix zugeordneten polarisierten Domänen der Polymerschicht simultan durch Druck/Zug aktiviert werden. Auf diese Weise können die der oberen Leiterbahn zugeordneten polarisierten Bereiche gleichzeitig abgefragt werden und dann durch ein Überwechseln auf eine andere obere Leiterbahn die entsprechenden anderen Bereiche aktiviert werden, so daß insgesamt ein selektiv paralleler Auslesemodus ermöglicht wird.

Es wurde gefunden, daß die piezoelektrische Aktivierung bei Verwendung von zwei gleich dicken Polymerschichten gelingt. Einer piezoelektrische Aktivierung der oberen Schicht mit 10 V steht eine Signalspannung an der Elektrodenmatrix von ~ 1 V gegenüber.

Die eingeschriebene Information, d. h. der Polarisationszustand der Polymerschicht, bleibt auch bei der piezoelektrischen oder pyroelektrischen Aktivierung unverändert erhalten. Die remanent polarisierte Polymerschicht stellt daher ein Speichersystem mit hoher Zeitstabilität und hoher Aufzeichnungsdichte dar. So existiert zum Beispiel das bei Si-Speichern bekannte Problem der $\alpha$-Strahlung, deren Einfluß in Form von Bit-Fehlern sich vor allem bei hoher Speicherdichte bemerkbar macht und aufwendige Korrekturverfahren erfordert, bei dem hier beschriebenen Speicher nicht. Die Löschung des Speichers kann durch Beaufschlagung des Speichers mit einem Wechselfeld abnehmender Amplitude erfolgen.

Zur Aktivierung beim Auslesen kann grundsätzlich die gleiche Elektrodenmatrix benutzt werden, die zum Einlesen der Information dient. Selbstverständlich können aber auch getrennte Leiterbahnen für die kurzzeitige globale oder lokale Aktivierung der Polymerschicht vorgesehen werden.

Alternativ kann das erfindungsgemäße Verfahren auch in der Weise durchgeführt werden, daß als Elektrodensystem eine Punkt-Matrix verwendet wird und alle polarisierten Domänen der Polymerschicht global durch elektromagnetische Strahlung oder durch einen im Elektrodensystem eingeprägten Heizstromimpuls pyroelektrisch oder piezoelektrisch durch Anwendung von Zug oder Druck aktiviert und die induzierten Signale parallel ausgelesen werden. Voraussetzung ist dafür allerdings, daß sämtliche Kontakte der Punktmatrix mit individuellen Anschlüssen versehen sind. Die Auswertung und Zuordnung der ausgelesenen Signale kann dann wiederum mit einem Multiplexer erfolgen. Eine andere Möglichkeit der Signalverarbeitung bei der globalen Aktivierung besteht darin, daß die induzierten Signale mittels Laufzeitanalyse parallel ausgelesen und den Speicherelementen (Domänen) der Polymerschicht zugeordnet werden.

Als Strahlungsquelle für die kurzzeitige Aufheizung der Polymerschicht bei der globalen pyroelektrischen Aktivierung hat sich eine handelsübliche Blitzlichtlampe bewährt.

Als Druckerzeuger für piezoelektrische Aktivierungen der Polymerschicht kann z. B. ein üblicher Piezokristall oder eine piezoelektrische Polymerschicht Verwendung finden.

Als Speichermaterialien werden vorteilhaft Polymere mit leicht polarisierbaren Atomen verwendet, z. B. Polyolefine mit Fluoratomen wie etwa das Polyvinylidenfluorid (PVDF) mit der Monomerformel

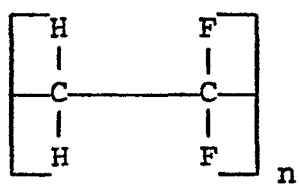

oder Polymere mit stark polarisierbaren Endgruppen verwendet, z. B. Polyolefine mit Cyangruppen wie etwa das Polyvinylidencyanid mit der Monomerformel

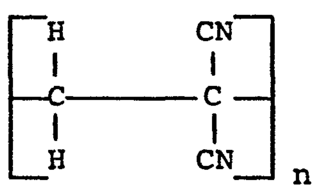

Dabei zeigt es sich, daß eine Optimierung der speichertechnischen Kenngrößen wie Koerzitivkraft, Polarisationsspannung, Rechteckigkeit der Hysteresekurve u.a. durch Copolymerisation oder durch Abmischung (Blend) mit anderen Polymeren erreicht werden kann. So sind beispielsweise anstelle von PVDF besser geeignet Copolymerisate von PVDF mit Trifluoroethylen ($PVF_3$) oder Abmischungen (Blends) mit Polymethylmethacylat (PMMA); anstelle von Polyvinylidencyanid sind besser geeignet Copolymere von Polyvinylidencyanid mit Polyvinylacetat u.a..

Für das erfindungsgemäße Verfahren werden Folien mit einer Dicke zwischen 0,1 und 2 µm bevorzugt.

Für diese Zwecke geeignete Folien mit hoher Isotopie und hohem Orientierungsgrad der Molekülketten erhält man, wenn man das Polymer aus einer Lösung zwischen Glasplatten zu Filmen eindampft oder das Copolymer unter Einwirkung eines elektrischen Feldes aus einer Schmelze erstarren läßt oder aus einer Lösung eindampft. Durch entsprechende Wahl der Verfahrensparameter können die wichtigen Daten der Polymerfolie, wie z. B. die Koerzitivkraft, die Rechteckigkeit der Hysterese-Kurve und die pyroelektrische bzw. piezoelektrische Konstante, eingestellt werden.

Der für das erfindungsgemäße Verfahren erforderliche Datenspeicher zeichnet sich durch einen einfachen Aufbau und durch eine hohe Betriebssicherheit aus. Das Kammelektrodensystem gewährleistet eine ausreichende Selektivität hinsichtlich der durch die Kreuzungspunkte der Streifen definierten Speicherelemente. Desgleichen werden beim Auslesen nur die adressierten Speicherelemente (Domänen) angesprochen. Interferenzerscheinungen zwischen benachbarten

Bezirken werden vermieden.

Eine Weiterentwicklung des Datenspeichers ist dadurch gekennzeichnet, daß mehrere Polymerschichten mit ihren Elektrodensystemen gitterartig übereinander angeordnet sind, gegebenenfalls mit isolierenden Zwischenschichten, so daß ein dreidimensionaler Speicherblock gebildet wird.

Mit dem erfindungsgemäßen Verfahren werden folgende Vorteile erzielt:

- Es hat sich gezeigt, daß eine sehr stabile elektrische Polarisation innerhalb kleiner Volumina erzeugt werden, d.h. es können hohe Speicherdichten bei langer Lebensdauer erreicht werden.

- Für die pyroelektrische Aktivierung genügen bereits kleine Temperaturänderungen und d.h. geringe Heizleistungen, um gut meßbare Auslesepotentiale zu erzeugen. In analoger Weise genügt bei der piezoelektrischen Aktivierung eine relativ geringe Druck/Zugbeanspruchung des polymeren Speichermaterials.

- Aufgrund der kleinen Dielektrizitätskonstanten des oben beschriebenen Copolymeren erhält man beim Auslesen mittels pyroelektrischer Aktivierung eine hohe Ausgangsspannung und daher ein gutes Signal Rausch-Verhältnis.

- Es können dünne resistente Folien aus diesem Copolymer hergestellt werden, deren Daten physikalisch im Hinblick auf den Anwendungszweck optimiert werden können (z. B. durch Recken, durch Tempern, gegebenenfalls im elektrischen Feld, und durch Einstellung der Schicht-

dicke).

- Die Information kann entweder in Form binärer Signale (Polarisationszustand 0 oder 1 oder auch -1 und +1) oder analog gespeichert werden. Bei der analogen Speicherung wird in jeder Speicherzelle eine Polarisation erzeugt, deren Wert der jeweiligen Signalamplitude entspricht.

Im folgenden wird die Erfindung anhand von Zeichnungen und Ausführungsbeispielen näher erläutert.

Es zeigen:

Fig. 1 das Ein- und Ausleseprinzip bei einem mit einem Elektrodensystem versehenen Polymer-Speicher auf der Basis pyroelektrischer Aktivierung,

Fig. 2 die Zeitabhängigkeit des durch den pyroelektrischen Effekt erzeugten Auslesesignals,

Fig. 3 das Ein- und Ausleseprinzip bei einem mit einem Elektrodensystem versehenen Polymer-Speicher auf der Basis einer piezoelektrischen Aktivierung

Der Polymer-Speicher gemäß Fig. 1 besteht aus einer 1 µm dicken, weitgehend uniaxial orientierten Folie 1, aus einem Copolymerisat von Polyvinylidenfluorid und Trifluoroethylen, deren Molekülketten weitgehend parallel zur Oberfläche gerichtet sind. Die gegenüberliegenden Flächen der Folie 1 sind mit einem Elektrodensystem kontaktiert. Das Elektrodensystem besteht aus je einer Elektrodenmatrix 2

und 3 auf der Ober- und Unterseite der Folie 1. Die Elektrodenmatrix 2 besteht ihrerseits aus einer Vielzahl paralleler Streifen $2_1...2_n$, die Elektrodenmatrix 3 aus einem analogen Streifensystem $3_1...3_m$, das jedoch mit den Streifen $2_1...2_n$ einen Winkel von $90^o$ einschließt. Das Elektrodensystem 2, 3 entspricht einem X-Y-Koordinatennetz in der Folienebene. Sämtliche Streifen sind mit Anschlüssen versehen. Durch einen Kreuzungspunkt der Streifen ist jeweils eine Speicherzelle 4 definiert. Beim Einlesen können entweder parallel auf einer Elektrode alle Kreuzungspunkte adressiert werden oder selektiv nur wenige Speicherbereiche belegt oder geändert werden.

Die Streifen bestehen z. B. aus Gold, Aluminium oder Nickel und werden durch Aufdampfen, Sputtern oder auf fotochemischem Wege direkt auf die Folien aufgebracht. Die Streifenbreite beträgt ca. 1 µm und der Abstand der Streifen variiert je nach gewünschter Speicherdichte zwischen 1 µm und 1000 µm.

Das Einlesen eines Signals erfolgt in der Weise, daß z. B. an die Elektroden $2_4$ und $3_3$ eine Gleichspannung $\pm U/2$ angelegt wird. Dadurch wird der im Kreuzungspunkt der Elektroden $2_4/3_3$ liegende Bereich 4 (punktierter Quader) remanent polarisiert; d.h. die Polarisation bleibt auch nach dem Abschalten der Spannung erhalten. Die zum Einlesen erforderliche elektrische Feldstärke liegt in der Größenordnung MV/cm, d.h. die erforderliche Spannung U liegt bei einer Foliendicke von 1 µm in der Größenordnung von 100 V. Die räumliche Ausdehnung des Bereiches 4 ist direkt mit der Streifenbreite korreliert, so daß z. B. bei einer Streifenbreite und einem Streifenabstand von 1 µm eine Spei-

cherdichte von $10^8$ bit/$cm^2$ im Binärcode erreicht wird. Der Binärcode wird durch Vorzeichenwechsel der remanenten Polarisation, d.h. durch Umpolen der Spannung $\pm U/2$, realisiert. Es ist jedoch auch eine Aufzeichnung auf Basis der Polarisationszustände 0 (keine Polarisation) und 1 (volle Polarisation) möglich. Darüber hinaus wurde gefunden, daß eine quasi analoge Aufzeichnung durch Beaufschlagung der Elektrodenmatrizen mit veränderlicher Spannung möglich ist. Die einzelnen Speicherzellen werden in diesem Fall unterschiedlich stark remanent polarisiert.

Zum Auslesen der in Form von Polarisationszuständen gespeicherten Information wird das gleiche Elektrodensystem 2, 3 benutzt. Es ist jedoch nicht möglich, die Polarisationszustände der durch die Kreuzungspunkte der Streifen $2_1...2_n$, $3_1...3_m$ definierten Speicherzellen direkt abzufragen, da die Polarisationsladungen durch freie Ladungsträger (Elektronen und Löcher) abgeschirmt werden, so daß nach außen kein elektrisches Feld auftritt. Wird dieses Gleichgewicht in einer polarisierten Domäne durch kurzzeitige Erwärmung gestört, so resultiert an den betreffenden Elektroden ein von Null verschiedenes Potential. Dieser Effekt wird zum Auslesen benutzt. Die thermische Aktivierung einer Speicherzelle in einem ferroelektrischen Aufzeichnungsmedium wird als pyroelektrische Aktivierung bezeichnet. Eine ausreichende pyroelektrische Aktivierung erhält man schon bei wenigen Grad C Temperaturerhöhung. Zu diesem Zweck wird, wie in Fig. 1 angedeutet, der Streifen $3_3$ kurzzeitig mit einem Heizstromimpuls beaufschlagt (Heizstromkreis 5), so daß durch die längs des Streifens erzeugte elektrische Leistung die gesamte über diesem Streifen befindliche Zone in der Polymer-Folie aufgeheizt wird. Hierbei wird die Joule'sche Heizleistung auf die Foliendicke und den Abstand der Elektroden so abgestimmt, daß ausschließlich die adressierten Bereiche signifikant erwärmt werden. An den Kreuzungspunkten des Streifens $3_3$ mit den Streifen $2_1$ bis $2_n$ werden dann die mit dem Heizstromimpuls korrelierten Signale in den betreffenden Elektrodenpaaren induziert, die parallel registriert werden können. In Fig. 1 ist aus Gründen der Übersichtlichkeit nur für die zwischen den Elektroden $2_4$ und $3_3$ liegende Speicherzelle 4 eine Auswerteschaltung 6 gezeichnet.

Nachdem die parallel anfallende Information dem zentralen Verarbeitungssystem 6 zugeführt worden ist, wird mittels eines Multiplexers 7 auf den Streifen $3_2$ geschaltet, so daß dann die in der Kreuzungspunkten von $3_2$ mit $2_1$ bis $2_n$ gespeicherten n-bits abgefragt werden können.

Zur Verdeutlichung des pyroelektrischen Auslesens ist im oberen Teil von Fig. 2 der Heizstromimpuls (Impulsdauer $t_H$) und im unteren Teil die dadurch hervorgerufene Spannung (z. B. an der Speicherzelle 4) als Funktion der Zeit dargestellt. In unserem Beispiel wurde mit $t_H = 1.10^{-6}$ sec eine Temperaturerhöhung von ca. $3^o$ C erzielt und Spannungen von ca. 1 V beobachtet. Die registrierte Anstiegszeit liegt im $10^{-9}$ Sekundenbereich, so daß die aus dieser Zeit und der Multiplexerzeit resultierende Zugriffszeit ebenfalls im $10^{-9}$ Sekundenbereich liegt.

Für die pyroelektrische Aktivierung mittels eines Heizstromimpulses wurde hier dasselbe Elektrodensystem benutzt, das zur Abfrage der gespeicherten Information dient. Selbstverständlich kann die Aufheizung auch durch getrennt aufgebrachte Leiterbahnen erfolgen. In diesem Fall enthält der Polymer-Datenspeicher neben den Elektrodenmatrizen 2 und 3 noch ein separates Heizdrahtsystem.

Anstelle eines Streifensystems 2, 3 kann auch eine Punktmatrix mit individuellen Anschlüssen auf die Polymer-Oberfläche aufgedampft werden.

Ein anderes Verfahren zur thermoelektrischen Aktivierung besteht darin, daß die Aktivierungsenergie nicht durch Joule'sche Wärme erzeugt wird, sondern durch elektromagnetische Strahlung. Praktisch geht man dabei so vor, daß man die gesamte Speicherfläche mit einem Blitzlicht beleuchtet und die gespeicherten Signale parallel ausgelesen werden. Wird in diesem Fall ein Polymer-Datenspeicher mit Punktmatrix als Elektrodensystem verwendet, so können die Speicherzellen mit Hilfe des Multiplexers selektiv angesprochen werden. Bei der Ausführung des Datenspeichers mit einer Streifenmatrix als Elektrodensystem ist eine direkte Zuordnung der ausgelesenen Signale zu den einzelnen Speicherelementen nicht möglich. Eine Zuordnung der Informationsinhalte zu den einzelnen Speicherzellen läßt sich aber erreichen, wenn die ausgelösten Signalimpulse einer Laufzeitanalyse unterzogen werden.

Bei der Anregung mit Licht kann neben der thermischen Anregung auch eine direkte fotoelektrische Anregung aufgrund eines inneren Fotoeffektes erfolgen. Es ist jedoch noch nicht geklärt, inwieweit ein solcher Effekt eine technisch ausschlaggebende Rolle spielt.

Der Polymer-Speicher gemäß Fig. 3 mit der Polymer-Folie 1 und den Elektrodenmatrizen 2,3 ist analog zu dem Speicher nach Fig. 1 aufgebaut. Auch der Einlesevorgang erfolgt in gleicher Weise wie auf Seite 15 bis 16 beschrieben.

Um die in Form von Polarisationszuständen gespeicherte Information auszulesen, wird der Aufbau nach Fig. 3 dahingehend erweitert, daß eine zweite Polymerschicht 8 in mechanisch festem Verbund (in der Zeichnung aus Gründen der Übersichtlichkeit abgehoben dargestellt) auf die erste mit Elektroden versehene Schicht aufgebracht ist.

Die zweite Polymerschicht ist völlig mit einer leitfähigen Deckschicht z. B. einem Metall bedeckt. Es ist nämlich nicht möglich, die Polarisationszustände der durch die Kreuzungspunkte der Streifen $2_1 \ldots\ldots 2_n$, $3_1 \ldots 3_m$ definierten Speicherzellen direkt abzufragen, da die Polarisationsladungen durch freie Ladungsträger abgeschirmt ist; erst durch Ausübung von Druck/Zug auf die Speicherzelle wird eine elektrische Spannung erzeugt.

Die Druckerzeugung gelingt durch Anlegen einer externen Spannung U von z. B. 10 V, z. B. zwischen dem Streifen $2_3$ und der leitfähigen Deckschicht 5 (in Fig. 3 angedeutet). Die Spannung führt in der piezoelektrischen zweiten Schicht zu einer Dickenänderung, die bei starrem Abstand zwischen Ober- und Unterseite des Gesamtaufbaus zu einem Druck/Zug auf die erste Polymerschicht führt.

Dieser Druck/Zug verursacht nun seinerseits eine elektrische Spannung zwischen dem Streifen $2_3$ und den kreuzenden Streifen $3_1 \ldots 3_m$. An den Kreuzungspunkten des Streifens $2_3$ mit den Streifen $3_1$ bis $3_m$ werden die Spannungen von z. B. 1 V induziert, die parallel registriert werden können. Die Korrelation übernimmt ein zentrales Verarbeitungssystem 9.

Nachdem die parallel anfallende Information dem zentralen Verarbeitungssystem 9 zugeführt worden ist, wird mittels eines Multiplexers 10 z. B. auf den Streifen $2_4$ geschaltet, so daß dann die in den Kreuzungspunkten von $2_4$ mit $3_1$ bis $3_m$ gespeicherten m/bits abgefragt werden können.

Anstelle eines Streifensystems 2, 3 kann auch eine Punktmatrix mit individuellen Anschlüssen auf die PVDF-Oberfläche aufgedampft werden.

Patentansprüche

1. Verfahren zum Ein- und Auslesen von binären oder analogen elektrischen Signalen unter Verwendung eines Datenspeichers auf Basis einer elektrisch polarisierbaren und mit einem Elektrodensystem kontaktierten Polymerschicht, die beim Einlesevorgang entsprechend den aufzuzeichnenden Signalen in lokalen Domänen remanent polarisiert wird und beim Auslesevorgang piezoelektrisch oder pyroelektrisch aktiviert wird, dadurch gekennzeichnet, daß die piezoelektrische oder pyroelektrische Aktivierung bei oder unmittelbar vor dem Auslesevorgang derart erfolgt, daß simultan eine Vielzahl der polarisierten Domänen im Elektrodensystem Signale induzieren, die dann parallel und/oder nach einem Multiplex-Verfahren zugeordnet und abgefragt werden.

2. Verfahren nach Anspruch 1, dadurch gekennzeichnet, daß die einer einzigen Leiterbahn des als Streifenmatrix ausgebildeten Elektrodensystems zugeordneten polarisierten Domänen der Polymerschicht simultan durch einen in dieser Leiterbahn fließenden Heizstromimpuls pyroelektrisch aktiviert werden, so daß bei Durchschalten dieser Leiterbahn mittels eines Multiplex-Verfahrens ein selektiv paralleler Auslesemodus erreicht wird.

3. Verfahren nach Anspruch 1, dadurch gekennzeichnet, daß als Elektrodensystem eine Punktmatrix verwendet wird und alle polarisierten Domänen der Polymerschicht global durch elektromagnetische Strahlung oder durch einen Heizstromimpuls in einer leitfähigen Schicht oder Leiterbahn, die auf der der

Punktmatrix gegenüberliegenden Seite der Polymerschicht angebracht ist, pyroelektrisch aktiviert und die induzierten Signale parallel ausgelesen werden.

4. Verfahren nach Anspruch 1, dadurch gekennzeichnet, daß als Elektrodensystem eine Streifenmatrix verwendet wird und daß die Polymerschicht global durch elektromagnetische Strahlung pyroelektrisch aktiviert wird und die induzierten Signale mittels Laufzeitanalyse parallel ausgelesen werden.

5. Verfahren nach Anspruch 1, dadurch gekennzeichnet, daß eine Spannung auf einer Leiterbahn bzgl. einer globalen Gegenelektrode eine lokale Dickenänderung in einer piezoelektrischen Schicht verursacht, die dann einen Druck/Zug auf die Speicherschicht ausübt, so daß im Elektrodensystem der Speicherschicht eine Spannung induziert wird und damit ein selektiv paralleler Auslesemodus erreicht wird.

6. Verfahren nach Anspruch 1, dadurch gekennzeichnet, daß als Elektrodensystem eine Punktmatrix verwendet wird und alle polarisierten Domänen der Polymerschicht global durch einen Druckgeber piezoelektrisch aktiviert wird und die induzierten Signale mittels Laufzeitanalyse parallel ausgelesen werden.

7. Verfahren nach Anspruch 1 bis 6, dadurch gekennzeichnet, daß eine Polymerschicht aus einem Polymer mit stark polarisierbaren Endgruppen, vorzugsweise Polyolefine, mit Cyangruppen oder Fluoratomen verwendet wird.

8. Verfahren nach Anspruch 1 bis 7, dadurch gekennzeichnet, daß Polymerschichten mit einer Dicke $\leq$ 10 µm, vorzugsweise mit einer Dicke zwischen 0,1 und 2 µm, verwendet werden.

9. Verfahren nach Anspruch 1 bis 8, dadurch gekennzeichnet, daß die in die Polymerschicht eingelesenen elektrischen Signale durch Beaufschlagung des Elektrodensystems mit einer Wechselspannung abnehmender Amplitude gelöscht werden.

10. Verfahren nach Anspruch 1 bis 9, dadurch gekennzeichnet, daß mehrere elektrisch polarisierbare Polymerschichten mit ihren Elektrodensystemen übereinander angeordnet und zu einem dreidimensionalen Speicherblock zusammengesetzt werden.

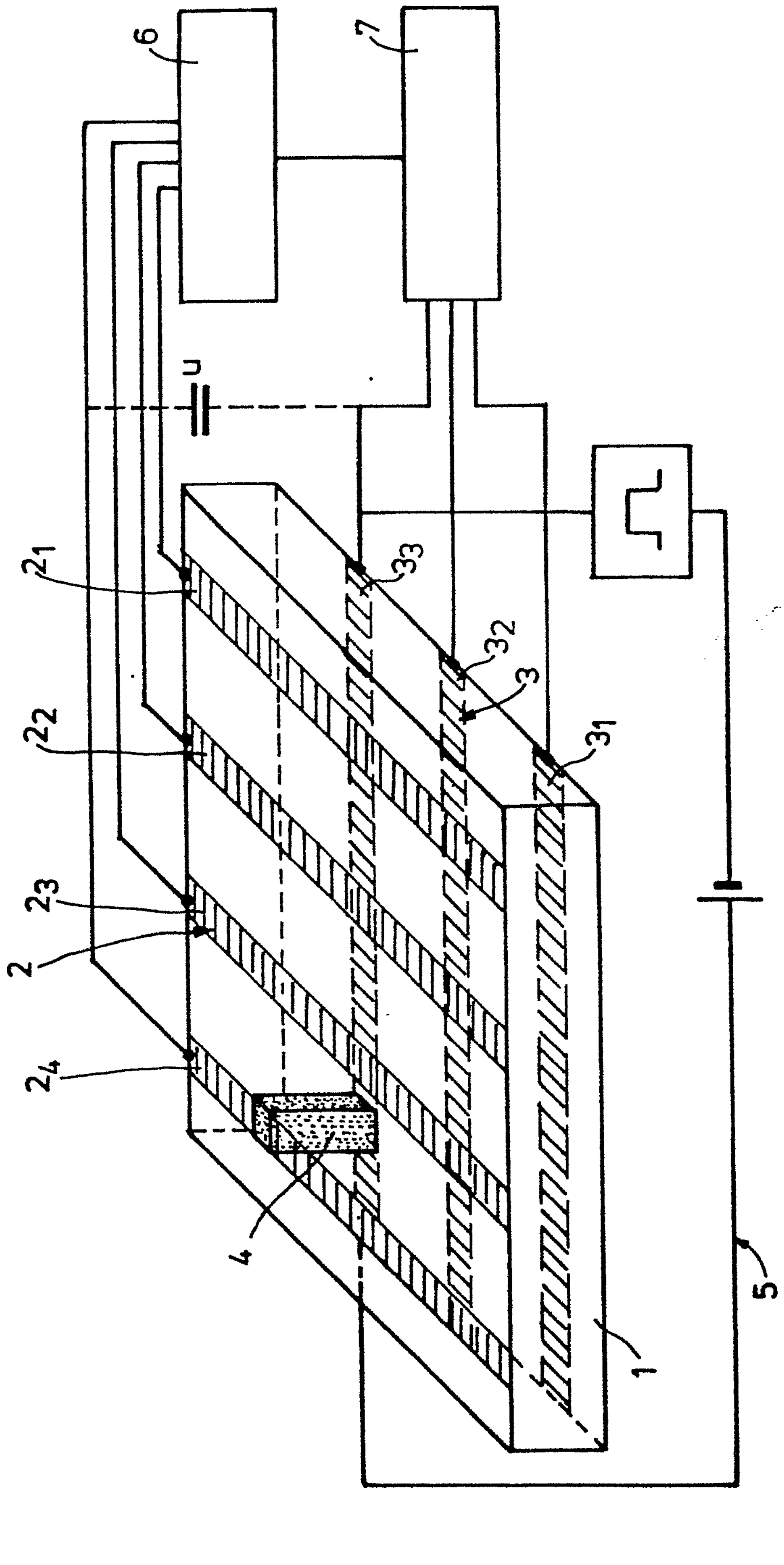


FIG. 1

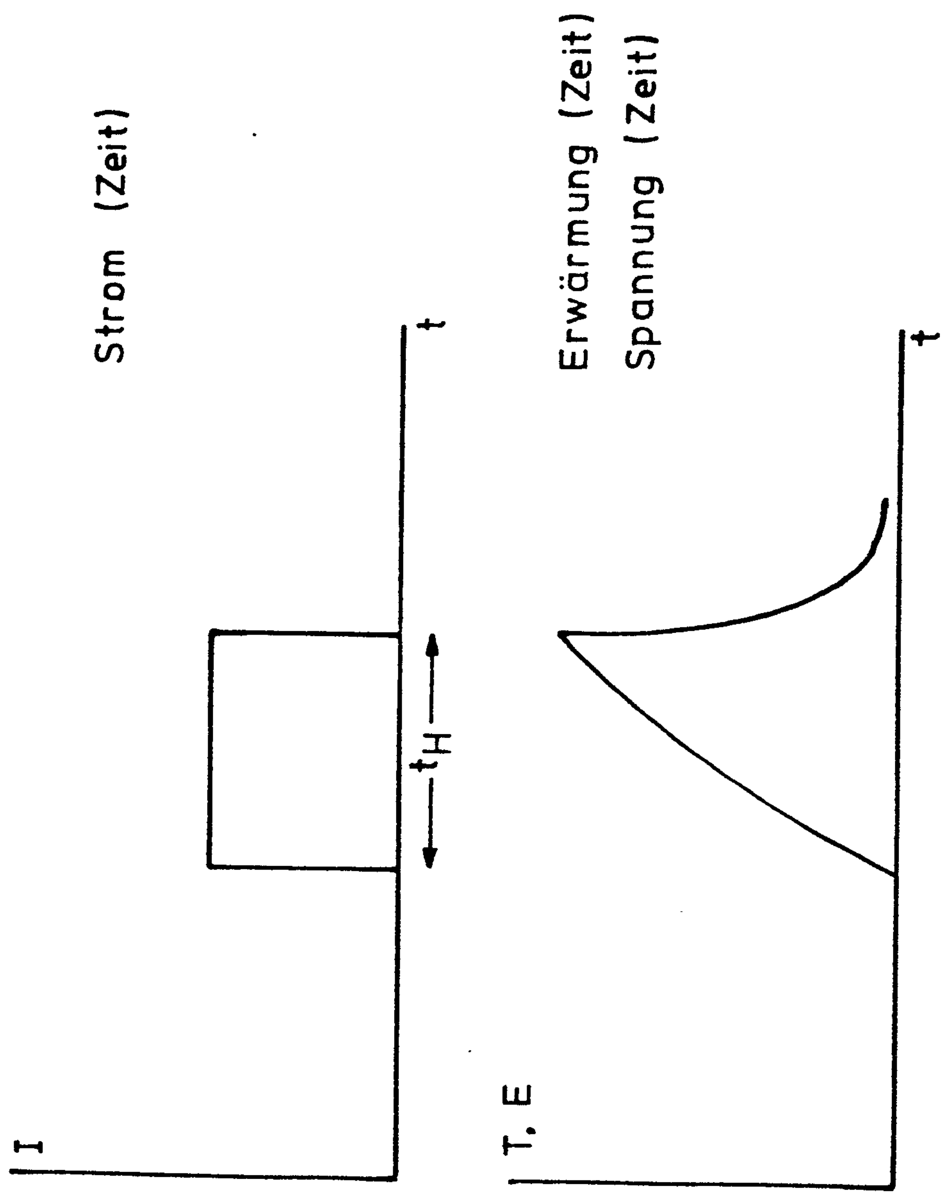


FIG. 2

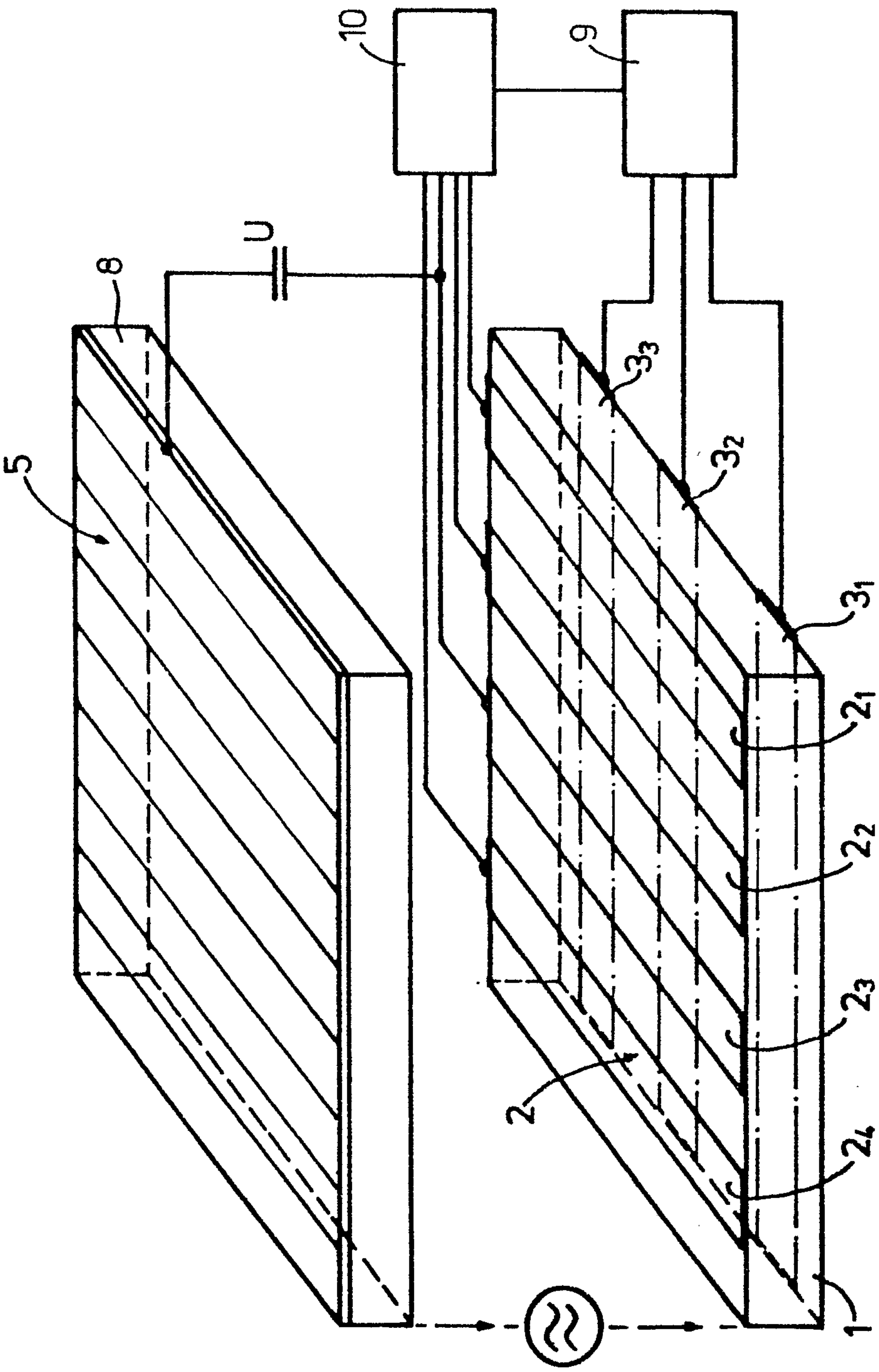


FIG. 3